# EUROPÄISCHE PATENTANMELDUNG

(11) **EP 0 657 930 A2**
(43) Veröffentlichungstag der Anmeldung: **14.06.1995**
(21) Anmeldenummer: 94118235.4
(22) Anmeldetag: 18.11.1994
(51) Int. Cl.: H01L 21/8238, H01L 27/092

(54) **Integrierte Schaltungsstruktur mit mindestens einem CMOS-NAND-Gatter und Verfahren zu deren Herstellung**

(30) Priorität: 07.12.1993 DE 4341667
(71) Anmelder: SIEMENS AKTIENGESELLSCHAFT, D-80333 München (DE)
(72) Erfinder: Risch, Lothar, Dr., D-85579 Neubiberg (DE); Hofmann, Karl, Dr., D-30974 Wennigsen (DE); Vogelsang, Thomas, Dipl.-Phys., Essex Junction, VT 05452 (US); Hofmann, Franz, Dr.Dipl.-Phys., D-80995 München (DE)

(57) **Zusammenfassung**

Ein erster MOS-Transistor und ein zweiter MOS-Transistor sind mit einem ersten komplementären MOS-Transistor und einem zweiten komplementären MOS-Transistor, die parallel verschaltet sind, in Serie geschaltet. Die Transistoren sind jeweils als vertikale Schichtenfolge (12, 13, 14; 14, 15, 16; 17, 18, 19) realisiert, die Source, Kanal und Drain umfaßt und die eine Flanke aufweist, an der ein Gatedielektrikum (112, 115, 118) und eine Gateelektrode (113, 116, 119) angeordnet sind. Die parallel verschalteten komplementären MOS-Transistoren sind in einer gemeinsamen Schichtenfolge (16, 17, 18) aus Source, Kanal und Drain realisiert. Die Schichtenfolgen (12, 13, 14; 14, 15, 16; 17, 18, 19), die die in Serie verschalteten Transistoren bilden, sind übereinander angeordnet. Die Schaltungsstruktur wird durch epitaktisches Abscheiden der Schichtenfolgen, insbesondere mit Hilfe von Molekularstrahlepitaxie, hergestellt.

## Beschreibung

In Planar-Silizium-Technologie werden Source, Kanalbereich und Drain eines MOS-Transistors lateral angeordnet. An der Oberfläche des Kanalbereichs wird ein Gatedielektrikum und eine Gateelektrode angeordnet. Die erreichbaren Gatelängen dieser MOS-Transistoren sowie die erzielbare Packungsdichte von aus einer Vielzahl von MOS-Transistoren zusammengesetzten integrierten Schaltungen sind abhängig vom Auflösungsvermögen der verwendeten Lithographie und von Toleranzen bei der Strukturierung und Justierung. In der 16 M-Generation werden typische Gatelängen von 0,6 µm, in der 64 M-Generation von 0,35 µm erreicht.

Durch Verbesserungen der optischen Lithographie sowie der Lack- und Ätztechnik wird eine weitere Reduzierung der lateralen Ausdehnung angestrebt. Wegen des begrenzten Auflösungsvermögens der optischen Lithographie und wegen zunehmender Probleme mit Toleranzen bei der Strukturierung und Justierung erscheint es jedoch fraglich, ob sich auf diese Weise reproduzierbar Transistoren mit Kanallängen unter 100 nm herstellen lassen.

Geringere Strukturgrößen in planarer Technologie können durch Verwendung von Elektronenstrahllithographie anstelle der optischen Lithographie erzielt werden. Im Labormaßstab ist es bisher gelungen, mit einem Elektronenstrahlschreiber einzelne funktionsfähige MOS-Transistoren mit Kanallängen bis zu 50 nm herzustellen. Die Elektronenstrahllithographie erscheint jedoch wegen ihrer geringen Prozeßgeschwindigkeit für einen Einsatz in einer Halbleiterfertigung aus wirtschaftlichen Gründen als ungeeignet.

Das Problem der erhöhten Packungsdichte tritt insbesondere bei komplexen logischen Schaltungen wie logischen Gattern auf, da dort mehrere n- und p-Kanal-Transistoren zusätzlich gegeneinander isoliert und miteinander verdrahtet werden müssen.

In der Einleitung zur Dissertation von W. Kiunke, 1992, Seite 2 bis 3, wird ein Überblick über Einsatzmöglichkeiten der Molekularstrahlepitaxie gegeben. Bei der Molekularstrahlepitaxie können kontrolliert homogene Schichten mit einer minimalen Dicke um eine Atomlage hergestellt werden. Durch Zugabe von Dotierstoff ist eine Dotierung der Schichten im Bereich von 10¹⁴ cm⁻³ bis 10²⁰ cm⁻³ insitu während der Epitaxie möglich. Als Anwendungsbeispiel wird über einen Vorschlag für einen vertikalen CMOS-Inverter berichtet. Der vorgeschlagene Inverter ist als Mesastruktur auf einem Substrat realisiert. Die Mesastruktur umfaßt eine npnpnp-Schichtenfolge mit senkrechten Flanken. An einer Seite sind sämtliche senkrechten Flanken der Schichten mit einem Gatedielektrikum und einer Gateelektrode versehen.

Der Erfindung liegt das Problem zugrunde, eine integrierte Schaltungsstruktur mit mindestens einem CMOS-NAND-Gatter anzugeben, in der eine erhöhte Packungsdichte erzielt wird. Insbesondere soll das NAND-Gatter MOS-Transistoren mit definierter Kanallänge im Bereich bis unter 50 nm aufweisen. Der Erfindung liegt weiterhin das Problem zugrunde, ein Herstellungsverfahren für die integrierte Schaltungsstruktur anzugeben.

Dieses Problem wird erfindungsgemäß gelöst durch eine integrierte Schaltungsstruktur nach Anspruch 1 sowie durch ein Verfahren zur Herstellung einer integrierten Schaltungsstruktur nach Anspruch 6. Weitere Ausgestaltungen der Erfindung gehen aus den übrigen Ansprüchen hervor.

In der erfindungsgemäßen Schaltungsstruktur umfaßt das CMOS-NAND-Gatter einen ersten MOS-Transistor und einen zweiten MOS-Transistor, die mit einem ersten komplementären MOS-Transistor und einem zweiten komplementären MOS-Transistor, die wiederum untereinander parallel verschaltet sind, in Serie geschaltet sind. Die MOS-Transistoren und die komplementären MOS-Transistoren sind dabei jeweils als vertikale Schichtenfolge realisiert. Die vertikale Schichtenfolge umfaßt Schichten entsprechend Source, Kanal und Drain. Die vertikale Schichtenfolge weist eine Flanke auf, die die Schichten schneidet und an der ein Gatedielektrikum und eine Gateelektrode angeordnet sind. Die parallel verschalteten komplementären MOS-Transistoren sind dabei in einer gemeinsamen Schichtenfolge aus Source, Kanal und Drain realisiert. Die Schichtenfolgen, die die in Serie verschalteten Transistoren bilden, sind übereinander angeordnet. Diejenigen Schichten, die Source- oder Draingebiete bilden, weisen dabei insbesondere eine Dicke zwischen 50 nm und 700 nm, vorzugsweise zwischen 100 nm und 400 nm, diejenigen, die einen Kanal bilden, zwischen 10 nm und 200 nm, vorzugsweise zwischen 50 nm und 100 nm, auf.

In der erfindungsgemäßen integrierten Schaltungsstruktur ist die laterale Ausdehnung des CMOS-NAND-Gatters durch Zahl und Anordnung der erforderlichen Anschlüsse für die MOS-Transistoren und die komplementären MOS-Transistoren bestimmt. Durch geschickte Anordnung der Schichten, Zusammenfassen von Schichten sowie Zusammenfassen von Anschlüssen werden in der integrierten Schaltungsstruktur hohe Packungsdichten erzielt.

Die Kanallänge der Transistoren ist bestimmt durch die Schichtdicke, in der die als Kanal wirkende Schicht jeweils hergestellt wird. Die Schichtenfolge wird vorzugsweise durch Epitaxie hergestellt. Mit Hilfe von Molekularstrahlepitaxie oder durch RTP-CVD (rapid thermal processing-chemical vapour deposition) mit SiH₂Cl₂-Gas können kontrolliert Schichtdicken bis unter 10 nm hergestellt werden.

Die erfindungsgemäße integrierte Schaltungsstruktur wird insbesondere auf der Basis eines Substrats realisiert, das mindestens im Bereich der Oberfläche, auf der die Schichtenfolge erzeugt wird, Silizium umfaßt. In diesem Fall kann die erfindungsgemäße Schaltungsstruktur mit anderen, in konventioneller Siliziumtechnologie realisierten Schaltelementen integriert werden. Das Substrat kann dazu sowohl ein Substrat aus monokristallinem Silizium als auch ein SOI-Substrat sein.

Zur Vermeidung von Überlappkapazitäten liegt es im Rahmen der Erfindung, die das CMOS-NAND-Gatter bildende Schichtenfolge von einer isolierenden Schicht zu umgeben.

Im folgenden wird die Erfindung anhand eines Ausführungsbeispiels und der Figuren näher erläutert.
- Figur 1: zeigt einen Schnitt durch ein erfindungsgemäßes CMOS-NAND-Gatter.
- Figur 2: zeigt ein Schaltbild des CMOS-NAND-Gatters.
- Figur 3: bis Figur 11 zeigt die Herstellung eines CMOS-NAND-Gatters, das von einer isolierenden Schicht umgeben ist.

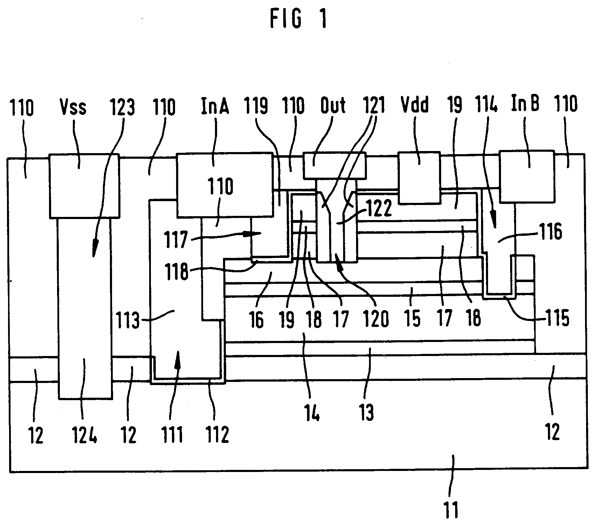

Auf der Oberfläche eines Substrats 11 aus zum Beispiel p-dotiertem, monokristallinem Silizium ist ganzflächig eine erste Schicht 12 aus n⁺-dotiertem Silizium angeordnet (siehe Figur 1). Die erste Schicht 12 weist eine Dicke von zum Beispiel 200 nm und eine Dotierstoffkonzentration von 10²⁰ cm⁻³ auf. Auf der Oberfläche der ersten Schicht 12 ist eine zweite Schicht 13 angeordnet, die aus p-dotiertem monokristallinem Silizium besteht und die eine Dicke von zum Beispiel 100 nm und eine Dotierstoffkonzentration von zum Beispiel 10¹⁸cm⁻³ aufweist.

Auf der Oberfläche der zweiten Schicht 13 ist eine dritte Schicht 14 angeordnet, die aus n⁺-dotiertem Silizium besteht, die eine Dicke von 700 nm und eine Dotierstoffkonzentration von 10²⁰ cm⁻³ aufweist.

Auf der Oberfläche der dritten Schicht 14 ist eine vierte Schicht 15 angeordnet, die aus p-dotiertem monokristallinem Silizium besteht und die eine Dicke von 100 nm und eine Dotierstoffkonzentration von 10¹⁸ cm⁻³ aufweist.

Auf der Oberfläche der vierten Schicht 15 ist eine fünfte Schicht 16 angeordnet. Die fünfte Schicht 16 besteht aus n⁺-dotiertem monokristallinem Silizium und weist eine Dicke von 200 nm und eine Dotierstoffkonzentration von 10²⁰ cm⁻³ auf.

Auf der Oberfläche der fünften Schicht 16 ist eine sechste Schicht 17 angeordnet, die aus p⁺-dotiertem monokristallinem Silizium besteht und die eine Dicke von 200 nm und eine Dotierstoffkonzentration von 10²⁰ cm⁻³ aufweist.

Auf der Oberfläche der sechsten Schicht 17 ist eine siebte Schicht 18 angeordnet, die aus n-dotiertem einkristallinem Silizium besteht und die eine Schichtdicke von 100 nm und eine Dotierstoffkonzentration von 10¹⁸ cm⁻³ aufweist.

Auf der Oberfläche der siebten Schicht 18 ist eine achte Schicht 19 angeordnet, die aus p⁺-dotiertem monokristallinem Silizium besteht und die eine Dicke von 200 nm und eine Dotierstoffkonzentration von 10²⁰ cm⁻³ aufweist.

Die zweite Schicht 13, die dritte Schicht 14, die vierte Schicht 15, die fünfte Schicht 16, die sechste Schicht 17, die siebte Schicht 18 und die achte Schicht 19 sind vollständig von einer isolierenden Schicht 110 aus zum Beispiel SiO₂ umgeben. Nur die erste Schicht 12 erstreckt sich auch unter die isolierende Schicht 110. Die erste Schicht 12 kann dabei als durchgehende Schicht oder als Wanne ausgebildet sein.

Es ist eine erste Öffnung 111 vorgesehen, die am Rand des Schichtaufbaus angeordnet ist und die von der Oberfläche des Schichtaufbaus bis zur Oberfläche des Substrats 11 reicht. Die an die Oberfläche der ersten Schicht 12, der zweiten Schicht 13 und der dritten Schicht 14 angrenzende Oberfläche der ersten Öffnung 111 ist mit einem ersten Gatedielektrikum 112 versehen. Die erste Öffnung 111 ist mit einer leitfähigen Struktur 113 aufgefüllt, die gegenüber der dritten Schicht 14, der vierten Schicht 15 und der fünften Schicht 16 durch einen Teil der isolierenden Schicht 110 isoliert ist. Die erste leitfähige Struktur 113 besteht zum Beispiel aus n⁺-dotiertem Polysilizium.

In der Schichtenfolge ist eine zweite Öffnung 114 vorgesehen, die von der Oberfläche der achten Schicht 19 mindestens bis auf die Oberfläche der dritten Schicht 14 reicht. Die Oberfläche der zweiten Öffnung, die an die dritte Schicht 14, die vierte Schicht 15, die fünfte Schicht 16, die sechste Schicht 17, die siebte Schicht 18 und die achte Schicht 19 angrenzt, ist mit einem zweiten Gatedielektrikum 115 versehen. Die zweite Öffnung 114 ist mit einer zweiten leitfähigen Struktur 116 aus zum Beispiel n⁺-dotiertem Polysilizium aufgefüllt. Zwischen der zweiten leitfähigen Struktur 116 und der dritten Schicht 14, der fünften Schicht 16, der sechsten Schicht 17 und der achten Schicht 19 wirkt das zweite Gatedielektrikum 115 als Isolationsstruktur. Gegenüber den übrigen Schichten und dem Substrat 11 ist die zweite leitfähige Struktur 116 isoliert.

In der Schichtenfolge ist eine dritte Öffnung 117 vorgesehen, die bis auf die Oberfläche der fünften Schicht 16 reicht. Die Oberfläche der dritten Öffnung 117, die an die fünfte Schicht 16, die sechste Schicht 17, die siebte Schicht 18 und die achte Schicht 19 angrenzt, ist mit einem dritten Gatedielektrikum 118 bedeckt.

Die dritten Öffnung 117 ist mit einer dritten leitfähigen Struktur 119 aus n⁺-dotiertem Polysilizium aufgefüllt. Zwischen der dritten leitfähigen Struktur 119 und der fünften Schicht 16, sechsten Schicht 17 sowie achten Schicht 19 wirkt das dritte Gatedielektrikum 118 als Isolationsstruktur.

In der Schichtenfolge ist eine vierte Öffnung 120 vorgesehen, die bis auf die Oberfläche der fünften Schicht 16 reicht. Die Seitenwände der vierten Öffnung 120 sind mit isolierenden Spacern 121 versehen. Die isolierenden Spacer 121 bedecken die Oberfläche der achten Schicht 19, der siebten Schicht 18 und der sechsten Schicht 17 vollständig. Zwischen den isolierenden Spacern 121 verbliebener Freiraum innerhalb der vierten Öffnung 120 ist mit einer vierten leitfähigen Struktur 122 aus zum Beispiel n⁺-dotiertem Polysilizium versehen. Die vierte leitfähige Struktur 122 kontaktiert die fünfte Schicht 16.

Seitlich der aus der zweiten Schicht 13 bis der achten Schicht 19 gebildeten Schichtenfolge ist eine fünfte Öffnung 123 vorgesehen. Die fünfte Öffnung 123 reicht mindestens bis in die erste Schicht 12 hinein. Oberhalb der ersten Schicht 12 ist die fünfte Öffnung 123 vollständig von der isolierenden Schicht 110 umgeben. Die fünfte Öffnung 123 ist mit einer fünften leitfähigen Struktur 124 aus n⁺-dotiertem Polysilizium gefüllt. Die erste leitfähige Struktur 113 und die dritte leitfähige Struktur 119 sind mit einem gemeinsamen Kontakt InA versehen. Die zweite leitfähige Struktur 116 ist mit einem Kontakt InB versehen. Die vierte leitfähige Struktur 122 ist mit einem Kontakt Out versehen. Die fünfte leitfähige Struktur 124 ist mit einem Kontakt Vss für eine erste Versorgungsspannung versehen. Die achte Schicht 19 ist mit einem Kontakt Vdd für eine zweite Versorgungsspannung versehen. Die Kontakte werden zum Beispiel aus Aluminium gebildet.

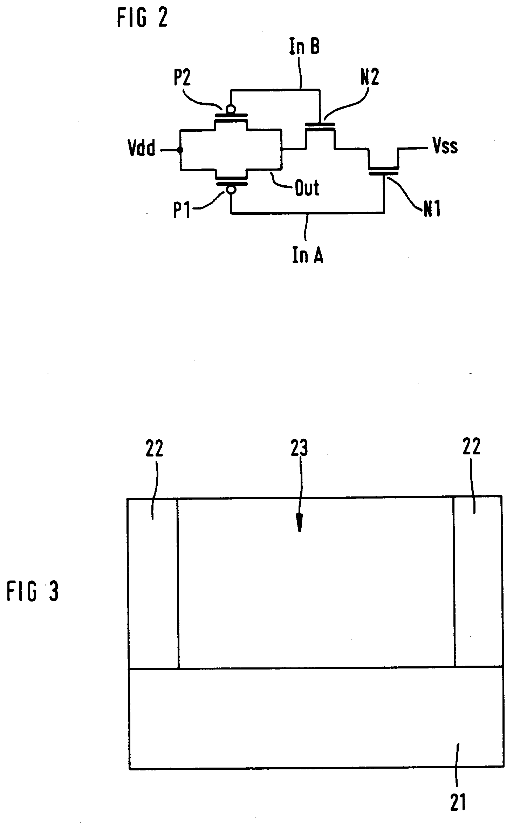

Die erste Schicht 12, die zweite Schicht 13 und die dritte Schicht 14 bilden Source, Kanal und Drain eines ersten n-Kanal-Transistors N1, zu dem die erste leitfähige Struktur 113 eine Gateelektrode bildet (siehe Figur 2). Die dritte Schicht 14, die vierte Schicht 15 und die fünfte Schicht 16 bilden einen zweiten n-Kanal-Transistor N2, zu dem die zweite leitfähige Struktur 116 eine Gateelektrode bildet. Die sechste Schicht 17, die siebte Schicht 18 und die achte Schicht 19 bilden Source, Kanal und Drain sowohl für einen ersten p-Kanal-Transistor P1, zu dem die zweite leitfähige Struktur 116 eine Gateelektrode bildet, als auch für einen zweiten p-Kanal-Transistor P2, zu dem die dritte leitfähige Struktur eine Gateelektrode bildet und der mit dem ersten p-Kanal-Transistor P1 parallel verschaltet ist. Die fünfte Schicht 16 ist mit der sechsten Schicht 17 über einen Tunneleffekt verbunden, der bei Dotierstoffkonzentrationen um 10²⁰ cm⁻³ auftritt. Die Kontakt InA und InB bilden die Eingänge des CMOS-NAND-Gatters und der Kontakt Out den Ausgang des CMOS-NAND-Gatters.

Bei der praktischen Realisierung dieses CMOS-NAND-Gatters wird die isolierende Schicht 110 in der Regel aus mehreren isolierenden Schichten zusammengesetzt realisiert werden.

Zur Herstellung eines erfindungsgemäßen CMOS-NAND-Gatters wird zum Beispiel auf ein Substrat 21 aus zum Beispiel p-dotiertem monokristallinem Silizium eine erste Isolationsschicht 22 aus zum Beispiel SiO₂ aufgebracht. Die erste Isolationsschicht 22 wird zum Beispiel durch thermische Oxidation oder durch CVD-Abscheidung hergestellt (siehe Figur 3). Die erste Isolationsschicht 22 wird in einer Dicke von zum Beispiel 1,5 µm aufgebracht.

In die erste Isolationsschicht 22 wird ein erstes Loch 23 geätzt. Das erste Loch 23 reicht bis auf die Oberfläche des Substrats 21. Parallel zur Oberfläche des Substrats 21 weist das erste Loch 23 einen im wesentlichen rechteckigen Querschnitt auf mit Kantenlängen von 4 µm . 4 µm. Das erste Loch 23 wird mit Hilfe einer ersten Maske geätzt.

Mit Hilfe von Epitaxie wird auf die freiliegende Oberfläche des Substrats 21 eine erste Schicht 24, darauf eine zweite Schicht 25, darauf eine dritte Schicht 26, darauf eine vierte Schicht 27, und darauf eine fünfte Schicht 28 aufgewachsen. Die Epitaxie erfolgt zum Beispiel durch Molekularstrahlepitaxie im Temperaturbereich zwischen 400 und 700°C und bei einem Druck von etwa 1 mbar oder durch selektive Epitaxie mit RTP-CVD (rapid thermal processing-chemical vapour depostion) mit SiH₂Cl₂-Gas, wobei die Schichten jeweils insitu mit einer Dotierung versehen werden. Dazu wird bei der Epitaxie entsprechender Dotierstoff zugegeben.

Die erste Schicht 24 wird in einer Dicke von 200 nm abgeschieden und mit einer Dotierstoffkonzentration von 10²⁰ cm⁻³ n⁺-dotiert. Die zweite Schicht 25 wird in einer Dicke von zum Beispiel 100 nm abgeschieden und mit einer Dotierstoffkonzentration von 10¹⁸ cm⁻³ p-dotiert. Die dritte Schicht 26 wird in einer Dicke von zum Beispiel 400 nm abgeschieden und mit einer Dotierstoffkonzentration von 10²⁰ cm⁻³ n⁺-dotiert. Die vierte Schicht 27 wird in einer Dicke von zum Beispiel 100 nm abgeschieden und mit einer Dotierstoffkonzentration von 10¹⁸ cm⁻³ p-dotiert. Die fünfte Schicht 28 wird in einer Dicke von zum Beispiel 200 nm abgeschieden und mit einer Dotierstoffkonzentration von 10²⁰ cm⁻³ n⁺-dotiert.

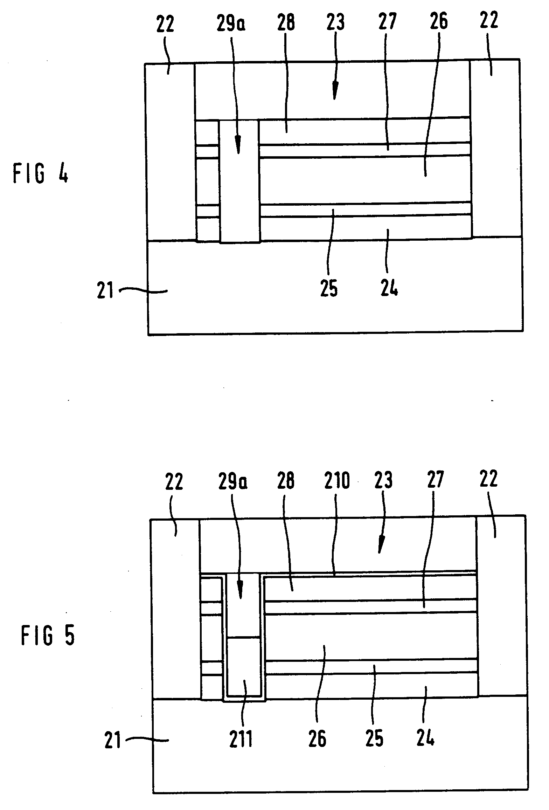

Es wird ein erster Teil 29a einer ersten Öffnung 29 erzeugt, der einer Seitenwand des ersten Loches 23 benachbart ist und der bis auf die Oberfläche des Substrats 21 reicht (siehe Figur 4). Der erste Teil 29a der ersten Öffnung 29 durchtrennt die Schichtenfolge bestehend aus erster Schicht 24, zweiter Schicht 25, dritter Schicht 26, vierter Schicht 27 und fünfter Schicht 28 von einer Seitenwand des ersten Loches 23 bis zur gegenüberliegenden Seitenwand des ersten Loches 23. Der erste Teil der ersten Öffnung 29a weist parallel zur Oberfläche des Substrats 21 eine Ausdehnung von etwa 0,6 µm x 4 µm auf.

Durch thermische Oxidation im Temperaturbereich zwischen 700 und 800°C wird eine erste dielektrische Schicht 210 erzeugt. Durch thermische Oxidation in diesem Temperaturbereich wächst SiO₂ auf der Oberfläche von Schichten, die eine Dotierstoffkonzentration von mindestens 10¹⁹ cm⁻³ aufweisen, etwa um einen Faktor 5 schneller auf als auf der Oberfläche von Schichten mit geringerer Dotierstoffkonzentration. Die Oxidation wird so durchgeführt, daß die erste dielektrische Schicht 210 im Bereich der Oberfläche der zweiten Schicht 25 eine Dicke von 5 nm aufweist. In diesem Bereich wirkt die erste dielektrische Schicht 210 als Gatedielektrikum. Auf der Oberfläche der ersten Schicht 24 sowie der dritten Schicht 26 dagegen wächst die dielektrische Schicht 210 mit einer um einen Faktor 5 größeren Dicke auf und wirkt hier als Isolationsstruktur.

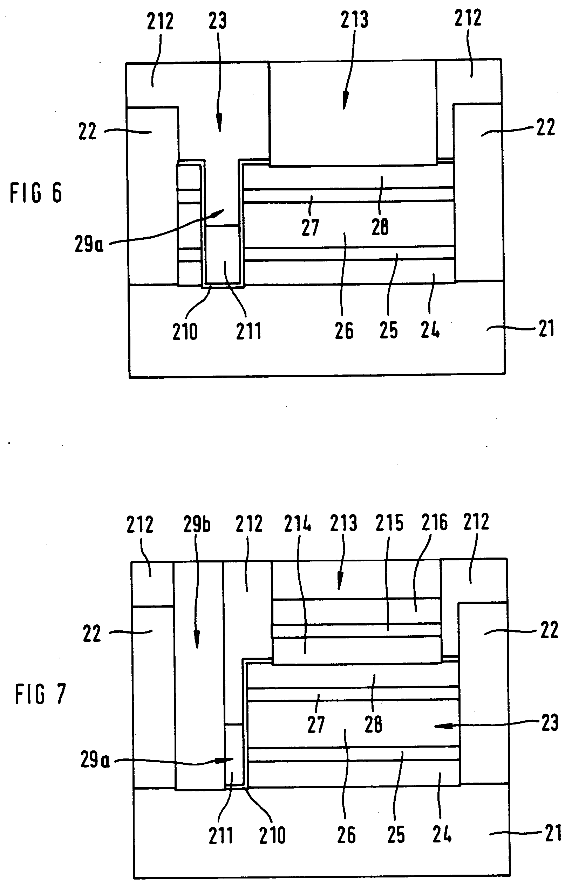

Der erste Teil 29a der ersten Öffnung 29 wird mit zum Beispiel n⁺-dotiertem Polysilizium 211 gefüllt. Durch Rückätzen wird die Höhe des Polysiliziums 211 so eingestellt, daß sie in etwa der Mitte der zweiten Schicht 25 entspricht (siehe Figur 5). Die Gesamtätzdicke beträgt dabei zum Beispiel 1,5 bis 0,5 µm.

Es wird ganzflächig eine zweite isolierende Schicht 212 abgeschieden, die den verbleibenden Freiraum im ersten Teil 29a der ersten Öffnung 29 und im ersten Loch 23 auffüllt. Die zweite isolierende Schicht 212 wird zum Beispiel aus SiO₂ gebildet und in einer Dicke von zum Beispiel 1,4 µm abgeschieden. In der zweiten isolierenden Schicht 212 wird unter Verwendung einer Photolithographie und eines anisotropen Ätzprozesses ein zweites Loch 213 erzeugt, das auf die Oberfläche der fünften Schicht 28 reicht. Das zweite Loch 213 wird so erzeugt, daß der erste Teil 29a der ersten Öffnung 29 mit der zweiten isolierenden Schicht 212 bedeckt bleibt (siehe Figur 6). In dem zweiten Loch 213 wird auf die Oberfläche der fünften Schicht 28 durch Epitaxie von Silizium eine sechste Schicht 214, darauf eine siebte Schicht 215 und darauf eine achte Schicht 216 aufgewachsen. Die Epitaxie erfolgt zum Beispiel als Molekularstrahlepitaxie im Temperaturbereich zwischen 400 und 700°C und bei einem Druck von etwa 1 mbar oder als selektive RTP-CVD-Epitaxie mit SiH₂Cl₂-Prozeßgas. Die Schichten werden durch Zugabe von entsprechendem Dotierstoff insitu dotiert abgeschieden. Die sechste Schicht 214 wird p⁺-dotiert mit einer Dotierstoffkonzentration von 10²⁰ cm⁻³. Die sechste Schicht 214 wird in einer Dicke von etwa 200 nm abgeschieden. Die siebte Schicht 215 wird in einer Dicke von etwa 100 nm abgeschieden und mit einer Dotierstoffkonzentration von etwa 10¹⁸ cm⁻³ n-dotiert. Die achte Schicht 216 wird in einer Dicke von etwa 200 nm abgeschieden und mit einer Dotierstoffkonzentration von etwa 10²⁰ cm⁻ ³ p-dotiert.

Ein zweiter Teil 29b der ersten Öffnung 29 wird so erzeugt, daß er den ersten Teil 29a der ersten Öffnung 29 teilweise überlappt und daß er sich mindestens bis an die benachbarte Seitenwand des ersten Loches 23 erstreckt (siehe Figur 7). Dazu wird mit Hilfe einer Photolithographie ein anisotroper Ätzprozeß durchgeführt. Innerhalb des zweiten Teiles 29b der ersten Öffnung 29 wird die Oberfläche des Substrat 21 freigelegt.

Der zweite Teil 29b der ersten Öffnung 29 wird mit einer Füllung 217 aus n⁺-dotiertem Polysilizium gefüllt. Durch Rückätzen des n⁺-dotierten Polysiliziums wird die Oberfläche der achten Schicht 216 freigelegt.

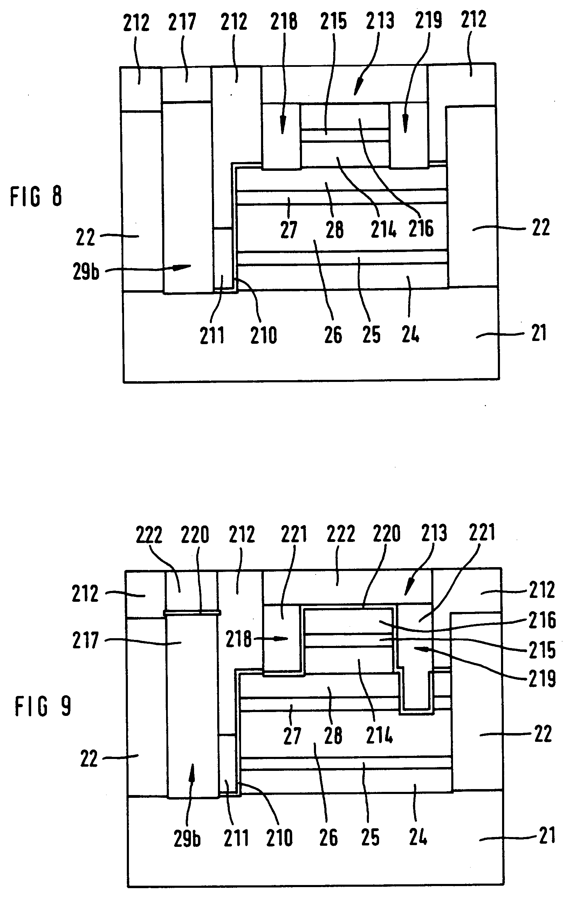

Entlang einander gegenüberliegenden Seitenwänden des zweiten Loches 213 werden eine zweite Öffnung 219 und eine dritte Öffnung 218 erzeugt. Dazu wird mit einer Phototechnik zunächst im Bereich der zweiten Öffnung 219 und der dritten Öffnung 218 ein anisotroper Ätzprozeß durchgeführt, der auf der Oberfläche der n⁺-dotierten fünften Schicht 25 stoppt (siehe Figur 8). Anschließend wird mit einer weiteren Photolithographie im Bereich der dritten Öffnung 218 abgedeckt und im Bereich der zweiten Öffnung 219 die Ätzung fortgesetzt, bis die Oberfläche der dritten Schicht 26 freigelegt ist (siehe Figur 9).

Durch thermische Oxidation im Temperaturbereich zwischen 700 und 800°C wird eine zweite dielektrische Schicht 220 erzeugt. Bedingt durch die unterschiedlichen Dotierstoffkonzentrationen in der sechsten Schicht 214, der achten Schicht 216, der fünften Schicht 28 und der dritten Schicht 26 einerseits sowie der vierten Schicht 27 und der siebten Schicht 215 andererseits wächst die zweite dielektrische Schicht 220 dabei an der Oberfläche der dritten Schicht 26, der fünften Schicht 28, der sechsten Schicht 214 und der achten Schicht 216 mit einer um den Faktor 5 größeren Dicke als auf der Oberfläche der vierten Schicht 27 und der siebten Schicht 215 auf. Auf der Oberfläche der vierten Schicht 27 und der siebten Schicht 215 wirkt die zweite dielektrische Schicht 220 als Gatedielektrikum. Auf der Oberfläche der achten Schicht 216, der sechsten Schicht 214, der fünften Schicht 28 sowie der dritten Schicht 26 dagegen wirkt die zweite dielektrische Schicht 220 aufgrund ihrer größeren Dicke als Isolationsstruktur.

Anschließend wird die zweite Öffnung 218 und die dritte Öffnung 219 jeweils mit einer weiteren Füllung 221 aus zum Beispiel n⁺-dotiertem Polysilizium aufgefüllt. Die Oberfläche der zweiten dielektrischen Schicht 220, die parallel zur Oberfläche des Substrats 21 auf der achten Schicht 216 angeordnet ist, bleibt dabei frei.

Anschließend wird verbleibender Freiraum in dem zweiten Teil 29b der ersten Öffnung sowie in dem zweiten Loch 213 durch Abscheiden einer dritten isolierenden Schicht 222 aus zum Beispiel SiO₂ aufgefüllt (siehe Figur 9).

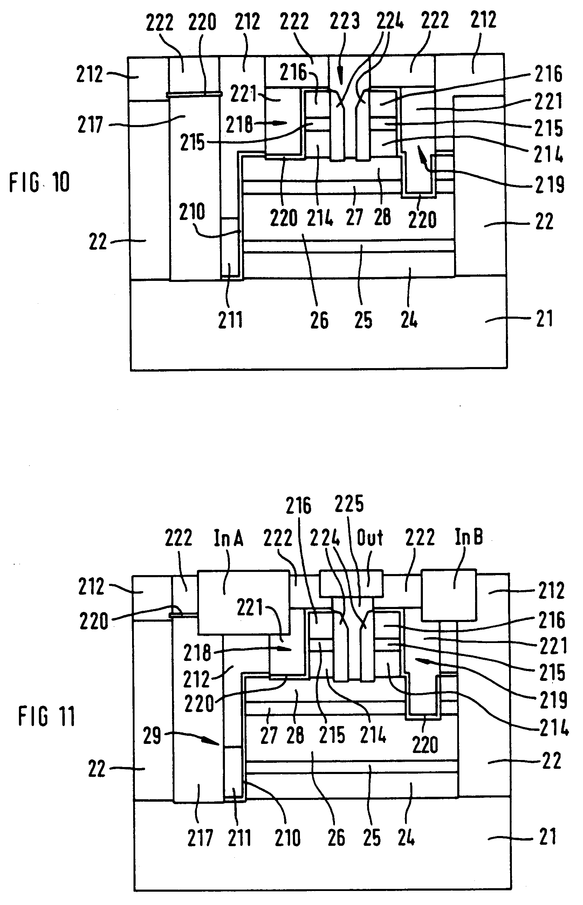

Zwischen der zweiten Öffnung 218 und der dritten Öffnung 219 wird mit Hilfe einer weiteren Photolithographie in einem anisotropen Ätzschritt eine vierte Öffnung 223 erzeugt, die bis auf die Oberfläche der fünften Schicht 28 reicht. Der dabei verwendete Ätzprozeß stoppt zum Beispiel auf n⁺-dotiertem Silizium (siehe Figur 10). An den Seitenwänden der vierten Öffnung 223, an denen die Oberfläche der sechsten Schicht 214, der siebten Schicht 215 und der achten Schicht 216 freiliegt, werden isolierende Spacer 224 aus zum Beispiel SiO₂ erzeugt.

In der vierten Öffnung 223 verbliebener Freiraum wird anschließend mit einer vierten leitfähigen Struktur 225 aus zum Beispiel n⁺-dotiertem Polysilizium aufgefüllt (siehe Figur 11). Schließlich werden Anschlüsse für das NAND-CMOS-Gatter hergestellt. Dazu werden Kontaktlocher geöffnet und mit Kontakten InA, InB sowie Out gefüllt. Die Kontakte bestehen zum Beispiel aus Aluminium. Der Kontakt InA reicht sowohl auf die Füllung 217 aus n⁺-dotiertem Polysilizium in der ersten Öffnung 29 als auch auf den Teil der weiteren Füllung 221 aus n⁺-dotiertem Polysilizium in der dritten Öffnung 218. Die Füllung 217 und das n⁺-dotierte Polysilizium 211 innerhalb der ersten Öffnung 29 bilden eine erste leitfähige Struktur, die als Gateelektrode für einen aus der ersten Schicht 24, der zweiten Schicht 25 und der dritten Schicht 26 und der ersten dielektrischen Schicht 210 gebildeten n-Kanal-Transistor. Die weitere Füllung 221 in der dritten Öffnung 218 bildet eine dritte leitfähige Struktur für einen aus der sechsten Schicht 214, siebten Schicht 215 und der achten Schicht 216 sowie der zweiten dielektrischen Schicht 220 gebildeten p-Kanal-Transistoren. Die erste leitfähige Struktur und die dritte leitfähige Struktur sind somit über den Kontakt InA miteinander verbunden. Der Kontakt InA stellt einen ersten Eingang des CMOS-NAND-Gatters dar.

Der Kontakt InB reicht auf den Teil der weiteren Füllung 221, der in der zweiten Öffnung 219 angeordnet ist. Dieser in der zweiten Öffnung 219 angeordnete Teil der weiteren Füllung 221 bildet eine zweite leitfähige Struktur, die eine Gateelektrode für einen zweiten n-Kanal-Transistor, der aus der dritten Schicht 26, der vierten Schicht 27, der fünften Schicht 28 und der zweiten dielektrischen Schicht 220 gebildet wird, sowie für einen zweiten p-Kanal-Transistor, der aus der sechsten Schicht 214, der siebten Schicht 215, der achten Schicht 216 sowie der zweiten dielektrischen Schicht 220 gebildet wird, darstellt. Der Kontakt Out bildet den Ausgang des CMOS-NAND-Gatters. Über die vierte leitfähige Struktur 225 schließt er die fünfte Schicht 28 an.

Außerhalb der gezeichneten Schnittebene werden die achte Schicht 216 sowie die erste Schicht 24 jeweils mit einem Kontakt versehen, über den eine erste Versorgungsspannung Vss an die erste Schicht 24 und eine zweite Versorgungsspannung Vdd an die achte Schicht 216 angelegt werden können.

## Patentansprüche

1. Integrierte Schaltungsstruktur mit mindestens einem CMOS-NAND-Gatter,
- bei dem ein erster MOS-Transistor (N1) und ein zweiter MOS-Transistor (N2) mit einem ersten komplementären MOS-Transistor (P1) und einem zweiten komplementären MOS-Transistor (P2), die untereinander parallel verschaltet sind, in Serie geschaltet sind,
- bei dem die Transistoren jeweils als vertikale Schichtenfolge (12, 13, 14; 14, 15, 16; 17, 18, 19), die jeweils Source, Kanal und Drain umfaßt und die eine Flanke aufweist, an der ein Gatedielektrikum (112, 115, 118) und eine Gateelektrode (113, 116, 119) angeordnet sind, realisiert sind,
- bei dem die parallel verschalteten komplementären MOS-Transistoren (P1, P2) in einer gemeinsamen Schichtenfolge (17, 18, 19) aus Source, Kanal und Drain realisiert sind,
- bei dem die Schichtenfolgen, die die in Serie verschalteten Transistoren bilden, übereinander angeordnet sind.

2. Schaltungsstruktur nach Anspruch 1,
- bei der auf einem Substrat (11) eine Schichtenfolge angeordnet ist, die eine erste Schicht (12) aus von einem ersten Leitfähigkeitstyp dotiertem Halbleitermaterial, darauf eine zweite Schicht (13) aus von einem zweiten zum ersten entgegengesetzten Leitfähigkeitstyp dotiertem Halbleitermaterial, darauf eine dritte Schicht (14) aus vom ersten Leitfähigkeitstyp dotiertem Halbleitermaterial, darauf eine vierte Schicht (15) aus vom zweiten Leitfähigkeitstyp dotiertem Halbleitermaterial, darauf eine fünfte Schicht (16) aus vom ersten Leitfähigkeitstyp dotiertem Halbleitermaterial, darauf eine sechste Schicht (17) aus vom zweiten Leitfähigkeitstyp dotiertem Halbleitermaterial, darauf eine siebte Schicht (18) aus vom ersten Leitfähigkeitstyp dotiertem Halbleitermaterial und darauf eine achte Schicht (19) aus vom zweiten Leitfähigkeitstyp dotiertem Halbleitermaterial umfaßt,
- bei der in der Schichtenfolge eine erste Öffnung (111) vorgesehen ist, die mindestens bis in die erste Schicht (12) hineinreicht, deren an die zweite Schicht (13) angrenzenden Oberfläche mit einem Gatedielektrikum (112) versehen ist und deren an die übrigen Schichten (12, 14) angrenzende Oberfläche mit einer ersten Isolationsstruktur (112) versehen ist und die mit einer ersten leitfähigen Struktur (113) versehen ist,
- bei der in der Schichtenfolge eine zweite Öffnung (114) vorgesehen ist, die bis auf die Oberfläche der dritten Schicht (14) reicht, deren an die vierte Schicht (15) und die siebte Schicht (18) angrenzende Oberfläche mit einem zweiten Gatedielektrikum (115) versehen ist und deren an die übrigen Schichten (14, 16, 17, 19) angrenzende Oberfläche mit einer zweiten Isolationsstruktur (115) versehen ist,
- bei der in der Schichtenfolge eine dritte Öffnung (117) vorgesehen ist, die bis in die sechste Schicht (17) hineinreicht, deren an die siebte Schicht (18) angrenzende Oberfläche mit einem dritten Gatedielektrikum (118) versehen ist und deren an die übrigen Schichten (16, 17, 19) angrenzende Oberfläche mit einer dritten Isolationsstruktur (118) versehen ist und die mit einer dritten leitfähigen Struktur (119) versehen ist,
- bei der in der Schichtenfolge eine vierte Öffnung (120) vorgesehen ist, die mindestens auf die Oberfläche der fünften Schicht (16) reicht und die mit einer vierten leitfähigen Struktur (122) versehen ist, die die fünfte Schicht (16) kontaktiert und die gegenüber den übrigen Schichten (17, 18, 19) des Schichtaufbaus isoliert ist,
- bei der die erste Schicht (12), die achte Schicht (19), die erste leitfähige Struktur (113), die zweite leitfähige Struktur (116), die dritte leitfähige Struktur (119) und die vierte leitfähige Struktur (122) jeweils mit Kontakten (Vss, Vdd, InA, InB, Out) versehen sind,
- bei dem die Kontakte zu der ersten leitfähigen Struktur (113) und zu der dritten leitfähigen Struktur (119) miteinander verbunden sind.

3. Schaltungsstruktur nach Anspruch 2,
bei der die erste leitfähige Struktur (113), die zweite leitfähige Struktur (116), die dritte leitfähige Struktur (119) und die vierte leitfähige Struktur (122) die erste Öffnung (111), die zweite Öffnung (114), die dritte Öffnung (117) bzw. die vierte Öffnung (120) jeweils im wesentlichen auffüllen.

4. Schaltungsstruktur nach Anspruch 2 oder 3,
bei der die Schichtenfolge so in einem Loch in einer isolierenden Schicht (110) angeordnet ist, daß mindestens die zweite Schicht (13), die dritte Schicht (14), die vierte Schicht (15), die fünfte Schicht (16), die sechste Schicht (17), die siebte Schicht (18) und die achte Schicht (19) ringförmig von der isolierenden Schicht (110) umgeben sind.

5. Schaltungsstruktur nach Anspruch 4,
- bei der die erste Schicht (12) mindestens teilweise unter der isolierenden Schicht (110) außerhalb des Loches angeordnet ist,
- bei der in der isolierenden Schicht (110) eine fünfte Öffnung (123) vorgesehen ist, die mindestens bis auf die Oberfläche der ersten Schicht (12) reicht und die mit einer fünften leitfähigen Struktur (124) versehen ist, die die erste Schicht (12) kontaktiert und die gegen das Substrat (11) isoliert ist.

6. Verfahren zur Herstellung einer integrierten Schaltungsstruktur mit mindestens einem CMOS-NAND-Gatter,
- bei dem auf eine Hauptfläche eines Substrats (11), das mindestens im Bereich der Hauptfläche des Substrats (11) Halbleitermaterial umfaßt, eine isolierende Schicht (110) aufgebracht wird,
- bei dem in der isolierenden Schicht (110) ein Loch erzeugt wird, in dem die Hauptfläche des Substrats (11) freigelegt wird,
- bei dem in dem Loch eine Schichtenfolge epitaktisch aufgewachsen wird, die eine erste Schicht (12) aus von einem ersten Leitfähigkeitstyp dotiertem Halbleitermaterial, darauf eine zweite Schicht (13) aus von einem zweiten zum ersten entgegengesetzten Leitfähigkeitstyp dotiertem Halbleitermaterial, darauf eine dritte Schicht (14) aus vom ersten Leitfähigkeitstyp dotiertem Halbleitermaterial, darauf eine vierte Schicht (15) aus vom zweiten Leitfähigkeitstyp dotiertem Halbleitermaterial, darauf eine fünfte Schicht (16) aus vom ersten Leitfähigkeitstyp dotiertem Halbleitermaterial, darauf eine sechste Schicht (17) aus vom zweiten Leitfähigkeitstyp dotiertem Halbleitermaterial, darauf eine siebte Schicht (18) aus vom ersten Leitfähigkeitstyp dotiertem Halbleitermaterial und darauf eine achte Schicht (19) aus vom zweiten Leitfähigkeitstyp dotiertem Halbleitermaterial umfaßt,
- bei dem eine erste Öffnung (111) erzeugt wird, die mindestens bis auf die Oberfläche der ersten Schicht (12) reicht, deren an die erste Schicht (12) angrenzende Oberfläche mit einem ersten Gatedielektrikum (112) versehen wird, deren an die übrigen Schichten der Schichtenfolge angrenzende Oberfläche mit einer Isolationsstruktur versehen wird und die mit einer ersten leitfähigen Struktur (116) versehen wird,
- bei dem in der Schichtenfolge eine zweite Öffnung (114) erzeugt wird, die bis auf die Oberfläche der dritten Schicht (14) reicht, deren an die vierte Schicht (15) und die siebte Schicht (18) angrenzende Oberfläche mit einem zweiten Gatedielektrikum (115) versehen wird und deren an die übrigen Schichten angrenzende Oberfläche mit einer zweiten Isolationsstruktur versehen ist und die mit einer zweiten leitfähigen Struktur (116) versehen wird,
- bei dem eine dritte Öffnung (117) erzeugt wird, die bis in die sechste Schicht (17) hineinreicht, deren an die siebte Schicht angrenzende Oberfläche mit einem dritten Gabedielektrikum (118) versehen wird und deren an die übrigen Schichten der Schichtenfolge angrenzende Oberfläche mit einer dritten Isolationsstruktur versehen wird und die mit einer dritten leitfähigen Struktur (119) versehen wird,
- bei dem eine vierte Öffnung (120) erzeugt wird, die mindestens bis auf die Oberfläche der fünften Schicht (16) reicht und die mit einer vierten leitfähigen Struktur (122) versehen wird, die die fünfte Schicht (16) kontaktiert und die gegenüber den übrigen Schichten der Schichtenfolge isoliert ist,
- bei dem eine fünfte Öffnung (123) erzeugt wird, die mindestens bis auf die Oberfläche der ersten Schicht (12) reicht und die so mit einer fünften leitfähigen Struktur (124) versehen wird, daß die fünfte leitfähige Struktur (124) die erste Schicht (12) kontaktiert und daß die fünfte leitfähige Struktur (124) gegenüber anderen, an die fünfte Öffnung (123) angrenzenden Schichten isoliert ist,
- bei dem die achte Schicht (19), die erste leitfähige Struktur (113), die zweite leitfähige Struktur (116), die dritte leitfähige Struktur (119), die vierte leitfähige Struktur (122) und die fünfte leitfähige Struktur (124) jeweils mit einem Kontakt (InA, InB, Out, Vss, Vdd) versehen werden.

7. Verfahren nach Anspruch 6,
- bei dem die Dotierstoffkonzentration in der zweiten Schicht (13), der vierten Schicht (15) und der siebten Schicht (18) jeweils im Bereich zwischen 5.10¹⁶ und 5.10¹⁸ cm⁻³ eingestellt wird,
- bei dem die Dotierstoffkonzentration in der ersten Schicht (12), der dritten Schicht (14), der fünften Schicht (16), der sechsten Schicht (17) und der achten Schicht (19) auf mindestens 10¹⁹ cm⁻³ eingestellt wird,
- bei dem das erste Gatedielektrikum (112), das zweite Gatedielektrikum (115) und das dritte Gatedielektrikum (118) jeweils in einer thermischen Oxidation im Temperaturbereich zwischen 700 und 800°C gebildet wird, wobei sich jeweils an der freiliegenden Oberfläche dotierter Schichten mit einer Dotierstoffkonzentration von mindestens 10¹⁹ cm⁻³ eine Oxidschicht größerer Dicke als dem jeweiligen Gatedielektrikum bildet, die als Isolationsstruktur wirkt.

8. Verfahren nach Anspruch 6 oder 7,
- bei dem das Aufwachsen der Schichtenfolge durch selektive Molekularstrahlepitaxie von Silizium im Temperaturbereich zwischen 400° und 700°C und im Druckbereich zwischen 0,1 und 10 mbar oder durch RTP-CVD (rapid thermal processing-chemical vapour deposition)-Epitaxie mit SiH₂Cl₂-Gas erfolgt,
- bei dem bei der Epitaxie jeweils entsprechender Dotierstoff zugegeben wird, so daß die einzelnen Schichten der Schichtenfolge insitu dotiert aufwachsen.

9. Verfahren nach einem der Ansprüche 6 bis 8,
- bei dem auf das Substrat (21) zunächst eine erste isolierende Schicht (22) aufgebracht wird, in der ein erstes Loch (23) geöffnet wird, in dem die Oberfläche des Substrats (21) freiliegt,
- bei dem in dem ersten Loch (23) in der ersten isolierenden Schicht (22) die erste Schicht (24), die zweite Schicht (25), die dritte Schicht (26), die vierte Schicht (27) und die fünfte Schicht (28) aufgewachsen werden,
- bei dem ein erster Teil (29a) einer ersten Öffnung erzeugt wird, der einer Seitenwand des ersten Loches (23) benachbart ist und der bis auf die Oberfläche des Substrats (21) reicht,
- bei dem durch thermische Oxidation das erste Gatedielektrikum (210) erzeugt wird,
- bei dem der erste Teil (29a) der ersten Öffnung mit dotiertem Polysilizium (211) bis in eine Höhe gefüllt wird, die mindestens der Unterkante und höchsten der Oberkante der dritten Schicht (26) entspricht,
- bei dem ganzflächig eine zweite isolierende Schicht (212) abgeschieden wird, die den verbleibenden Freiraum im ersten Teil (29a) der ersten Öffnung und im ersten Loch (23) auffüllt,
- bei dem in der zweiten isolierenden Schicht (212) ein zweites Loch (213) erzeugt wird, das auf die Oberfläche der fünften Schicht (28) reicht, so daß der erste Teil (29a) der ersten Öffnung und der zweiten isolierenden Schicht (212) bedeckt bleibt,
- bei dem in dem zweiten Loch (213) auf die Oberfläche der fünften Schicht (28) die sechste Schicht (214), darauf die siebte Schicht (215) und darauf die achte Schicht (216) aufgewachsen werden,
- bei dem ein zweiter Teil (29b) der ersten Öffnung erzeugt wird, der den ersten Teil (29a) der ersten Öffnung teilweise überlappt und der sich mindestens bis an die benachbarte Seitenwand des ersten Loches (23) erstreckt,
- bei dem der zweite Teil (29b) der ersten Öffnung mit dotiertem Polysilizium (217) gefüllt wird,
- bei dem entlang einander gegenüberliegenden Seitenwänden des zweiten Loches (213) die zweite Öffnung (219) und die dritte Öffnung (218) erzeugt werden, die sich jeweils mindestens bis an die benachbarte Seitenwand des zweiten Loches (213) erstrecken, wobei die zweite Öffnung (219) bis in die dritte Schicht (26) hineinreicht und die dritte Öffnung (218) bis auf die Oberfläche der fünften Schicht (28) reicht,
- bei dem durch thermische Oxidation das zweite Gatedielektrikum (220) und das dritte Gatedielektrikum (220) erzeugt werden,
- bei dem die zweite Öffnung (219) und die dritte Öffnung (218) mit dotiertem Polysilizium (221) gefüllt werden,
- bei dem verbleibender Freiraum in der ersten Öffnung (29) und in dem zweiten Loch (213) durch Abscheiden einer dritten isolierenden Schicht (222) aufgefüllt wird,
- bei dem zwischen der zweiten Öffnung (219) und der dritten Öffnung (218) die vierte Öffnung (223) erzeugt wird, die bis auf die Oberfläche der fünften Schicht (28) reicht,
- bei dem die Seitenwände der vierten Öffnung (223) mit isolierenden Spacern (224) versehen werden und der verbliebene Freiraum in der vierten Öffnung (223) mit dotiertem Polysilizium (225) aufgefüllt wird.

10. Verfahren nach Anspruch 9,
- bei dem in der Oberfläche des Substrats (21) vor der Abscheidung der ersten isolierenden Schicht (22) ein vom ersten Leitfähigkeitstyp dotiertes Gebiet erzeugt wird, das in seiner lateralen Ausdehnung das erste Loch (23) in der ersten isolierenden Schicht (22) seitlich überlappt,
- bei dem seitlich des ersten Loches (23) eine fünfte Öffnung erzeugt wird, die bis auf die Oberfläche des dotierten Gebietes reicht und die mit dotiertem Polysilizium aufgefüllt wird.
